(19) **Europäisches Patentamt**

**European Patent Office**

**Office européen des brevets**

(11) Veröffentlichungsnummer: **0 007 629**
**B1**

(12) **EUROPÄISCHE PATENTSCHRIFT**

(45) Veröffentlichungstag der Patentschrift: **27.05.81**

(51) Int. Cl.³: **H 03 H 15/02, H 01 L 27/10**

(21) Anmeldenummer: **79102652.9**

(22) Anmeldetag: **25.07.79**

(54) Elektrische Filterschaltung mit aus einzelnen CTD-Elementen bestehenden CTD-Leitungen.

(30) Priorität: **26.07.78 DE 2832849**

(43) Veröffentlichungstag der Anmeldung:
**06.02.80 Patentblatt 80/3**

(45) Bekanntmachung des Hinweises auf die Patenterteilung:
**27.05.81 Patentblatt 81/21**

(84) Benannte Vertragsstaaten:
**AT BE CH FR IT NL SE**

(56) Entgegenhaltungen:
**DE - A - 2 608 540**
**DE - A - 2 702 680**

(73) Patentinhaber: **SIEMENS AKTIENGESELLSCHAFT**
**Berlin und München**
**Postfach 22 02 61**
**D-8000 München 22 (DE)**

(72) Erfinder: **Betzl, Hermann, Dipl.-Ing.**
**Albert-Rosshaupterstrasse 130**
**D-8000 München 70 (DE)**
Erfinder: **Hebenstreit, Ernst, Dipl.-Ing.**
**Gunzenlehstrasse 26**
**D-8000 München 21 (DE)**
Erfinder: **Schreiber, Roland, Dr.-Ing.**
**Hohenbrunnerstrasse 61**
**D-8012 Ottobrunn-Riemerling (DE)**

Elektrische Filterschaltung mit aus einzelnen CTD-Elementen bestehenden CTD-Leitungen

Die Erfindung betrifft eine elektrische Filterschaltung mit aus einzelnen CTD-Elementen bestehenden CTD-Leitungen unter Verwendung von Vierpolresonatoren, die jeweils als in sich geschlossene Leitungsschleife ausgebildet sind und die das frequenzabhängige Übertragungsverhalten der Filterschaltung bestimmen, und bei der weiterhin aufeinanderfolgende Vierpolresonatoren über eine Koppelschaltung miteinander verbunden sind.

Filterschaltungen der vorgenannten Art sind beispielsweise dem Grundkonzept nach bereits aus der DE—PS 24 53 669 bekannt geworden. Spezielle Ausgestaltungen solcher Schaltungen sind ferner in der DE—AS 25 34 319 sowie auch in der DE—AS 26 08 582 beschrieben. In diesen Druckschriften ist u.a. auch darauf hingewiesen, daß unter CTD-Leitungen einerseits sogenannte BBD-Anordnungen (Bucked Brigade Devices), also sogenannte Eimerkettenschaltungen und andererseits auch sogenannte CCD-Anordnungen (Charged Coupled Devices) zu verstehen sind. CCD-Schaltungen sind solche Einrichtungen, die nach dem Prinzip der gekoppelten Ladungen arbeiten. Es hat sich für diese beiden Schaltungsarten in der Fachsprache auch die Bezeichnung "CTD-Einrichtung" (Charge Transfer Device) eingebürgert, und es ist für diese Art von Übertragungseinrichtungen u.a. charakteristisch, daß sie unidirektionales Übertragungsverhalten haben. CTD-Einrichtungen bestehen aus einer größeren ganzzahligen Anzahl, also beispielsweise n einzelnen CTD-Elementen, die als vollintegrierbare Gesamtanordnungen realisiert werden können. Bekanntlich müssen solche CTD-Anordnungen über ein Taktsignal mit einer vorgebbaren Taktfrequenz $f_T$ betrieben werden, wobei das Taktsignal den einzelnen Umladekondensatoren der BBD-Anordnungen bzw. den Umladekapazitäten der CCD-Leitungen zugeführt wird. In der Praxis werden dabei sogenannte Mehrphasen-CTD-Anordnungen bevorzugt, deren Taktsignale zueinander phasenverschoben sind, und zwar derart, daß benachbarte Umladekapazitäten mit phasenverschobenen Takten betrieben werden. Wenn man demzufolge ein sogenanntes p-Phasentaktsystem (p=2,3,4 ...) verwendet, dann besteht ein CTD-Element aus p benachbarten Umladekapazitäten. Weitere Einzelheiten hierüber finden sich z.B. in dem Buch "Charged Transfer Devices", Academic Press. Inc., New York, San Francisco, London 1975.

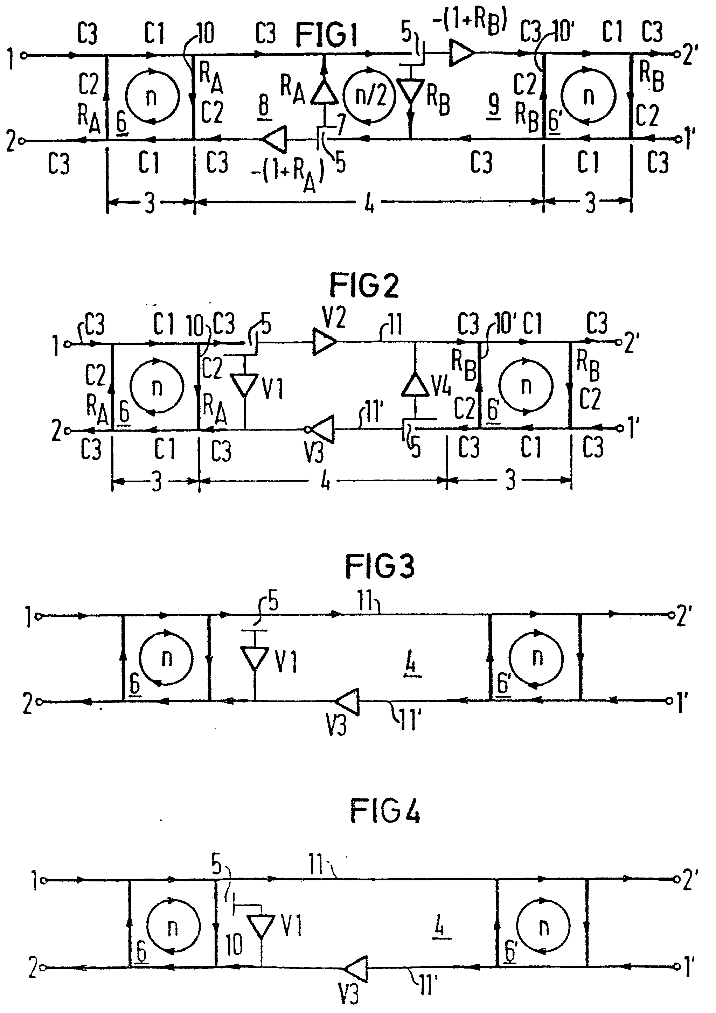

Filterschaltungen nach der DE—PS 24 53 669 bzw. nach der DE—AS 25 34 319 bzw. auch nach der DE—AS 26 08 582 verwenden als resonanzfähige Strukturen in sich geschlossene Leitungsschleifen, die im folgenden als Vierpolresonatoren bezeichnet werden. In der DE—AS 25 34 319 sind noch Ein- und Auskoppelschaltungen gezeigt, die in der Topologie von Kreuzgliedschaltungen ausgebildet sind, wobei für den Schatungsaufbau die Eigenschaften der CTD-Anordnungen berücksichtigt werden müssen. Bei den in der DE—AS 26 08 582 gezeigten Ein- und Auskoppelschaltungen wird hinsichtlich der Schaltungsstruktur die Topologie von $\pi$-Gliedern verwendet. Wie im folgenden anhand der Fig. 1 noch gezeigt wird, eignen sich solche Ein- bzw. Auskoppelschaltungen auch als Zwischenkopplungen, dann, nämlich, wenn es darum geht, eine mehrgliedrige Filterstruktur zu realisieren, in der zwei oder mehrere Vierpolresonatoren über geeignete Koppelschaltungen in Kette geschaltet sind. Für die Filtercharakteristik ist dabei mitbestimmend das Verhältnis der Umladekapazitäten der in den Zuführungsleitungen verwendeten CTD-Anordnungen zu der Umladekapazität der in der geschlossenen Leiterscheife, d.h. also zu der im Vierpolresonator verwendeten CTD-Anordnung.

Obzwar die bekannten Filterschaltungen nur einen verhältnismäßig geringen Raumverbrauch auf Grund ihrer integrierten Aufbauweise in Anspruch nehmen, zeigt sich doch, daß insbesondere für die Koppelschaltung verhältnismäßig viele CTD-Elemente erforderlich sind.

Der Erfindung liegt die Aufgabe zugrunde, Filterschaltungen anzugeben, die aus mehreren in Kette, geschalteten CTD-Vierpolresonatoren bestehen, und bei denen für die zwischen den einzelnen Vierpolresonatoren liegenden Koppelschaltungen eine möglichst einfache Struktur haben, so daß also eine möglichst geringe Anzahl von CTD-Elementen bzw. CTD-Leitungen bzw. Verstärken erforderlich ist.

Ausgehend von den einleitend genannten Filterschaltungen, wird diese Aufgabe erfindungsgemäß dadurch gelöst, daß parallel zum Ein- und/oder Ausgang des einzelnen Vierpolresonators Verstärker geschaltet sind, deren Signalflußrichtung übereinstimmt mit der der parallel liegenden CTD-Leitung, und daß aufeinanderfolgende Vierpolresonatoren verbindende Längsleitungen der Koppelschaltung unidirektionales Übertragungsverhalten haben und in wenigstens einer dieser Längsleitungen ein invertierender Verstärker enthalten ist.

In den Unteransprüchen sind noch weitere vorteilhafte Ausgestaltungen angegeben.

Anhand von Ausführungsbeispielen wird nachstehend die Erfindung noch näher erläutert.

Es zeigen in der Zeichnung

Fig. 1 in schematischer Darstellung das Grundkonzept von Filterschaltungen wie sie durch die DE—PS 24 53 669, die DE—AS 25 34 319 und die DE—AS 26 08 582 bekannt geworden sind;

Fig. 2 das Grundprinzip einer erfindungsgemäßen Koppelschaltung unter Verwendung von vier Verstärkern;

Fig. 3 eine weitere Ausgestaltung einer Koppelschaltung, bei der aufeinanderfolgende Vierpolresonatoren über eine CTD-Längsleitung miteinander verbunden sind, aus der unmittelbar das Signal für einen im Querzweig liegenden Verstärker ausgekoppelt wird;

Fig. 4 eine weitere Schaltungsmöglichkeit, bei der das Signal für den im Querzweig liegende Verstärker aus dem parallelliegenden Leitungszweig des vorgeschalteten Vierpolresonators ausgekoppelt wird.

Wie bereits erwähnt, ist in Fig. 1 zum besseren Verständnis des Erfindungsgegenstandes eine bekannte Schaltungsstruktur gezeichnet, deren Grundkonzept in der DE—AS 26 08 582 angegeben ist. Die breit ausgezogenen Linien stellen dabei CTD-Leitungen dar, deren unidirektionales Übertragungsverhalten durch die in die einzelnen Leitungsabschnitte miteingetragenen Pfeile kenntlich gemacht ist. Auch sind die Kapazitätswerte der Umladekapazitäten C1, C2 usw. unmittelbar an den einzelnen CTD-Leitungsabschnitten angegeben. Die in der Figur dünn gezeichneten Linien sind galvanische Leitungsverbindungen, deren unidirektionales Übertragungsverhalten durch die Signalflußrichtungen der in diese Leitungen eingeschalteten Verstärker bestimmt wird. Als Beispiel ist ein zweikreisiges Filter gezeigt, dessen Vierpolresonatoren 6 und 6' über eine Koppelschaltung miteinander verbunden sind. Zur einfacheren Darstellung wird angenommen, daß die Vierpolresonatoren 6 und 6' unter sich gleich aufgebaut sind, so daß in der Schaltung die Abschnitte 3, 4 und 3 entstehen. In der Schaltung ist ferner zu erkennen ein Eingangsanschluß 1 sowie ein Ausgangsanschluß 2 und weiterhin ein Ausgangsanschluß 2' und ein weiterer Eingangsanschluß 1'. Den Ein- bzw. Ausgangsanschlüssen können dabei an sich bekannte Schaltungen vor- bzw. nachgeschaltet sein, die geeignet sind, ein Analogsignal in ein für CTD-Leitungen geeignetes Signal umzuwandeln bzw. umgekehrt ein auf CTD-Leitungen übertragenes Signal in ein Analogsignal zurückzuverwandeln. Hierfür mögliche Schaltungen sind beispielsweise in dem eingangs erwähnten Buch "Charged Transfer Devices", insbesondere auf den Seiten 47 bis 61 beschrieben. In den Schaltungsabschnitten 3 haben die CTD-Längsleitungen die Umladekapazität C1 während die CTD-Querleitungen die Umladekapazität C2 haben. Durch den in sich geschlossenen Kreis soll kenntlich gemacht werden, daß jeder der Vierpolresonatoren 6, 6' n CTD-Elemente hat, wodurch für die jeweils in sich geschlossene Leitungsschleife auch die Resonanzfrequenz $f_R$ festgelegt ist. Die Koppelschaltung 4 besteht für sich aus einem Koppelring 7, dem der Schaltungsabschnitt 8 vorgeschaltet und der Schaltungsabschnitt 9 nachgeschaltet ist. Im Koppelring 7 ist kenntlich gemacht, daß die sich dort ergebende, ebenfalls eine geschlossene Leitungsschleife darstellende Schaltung hinsichtlich der verwendeten CTD-Leitungen so ausgebildet ist, daß insgesamt n/2 CTD-Elemente auftreten. Im vorgeschalteten Leitungsabschnitt 8 hat die dort verwendete CTD-Leitung die Umladekapazität C3, ebenso kann auch die der nachfolgenden Schaltung 9 die Umladekapazität C3 haben. Im Koppelring 7 sind ferner zu erkennen zwei mit der Bezugsziffer 5 kenntlich gemachte Schaltsymbole, die eine sogenannte leistungslose Auskopplung darstellen. Als Beispiel sind solche leistungslosen Auskopplungen für CCD-Schaltungen insbesondere auf Seite 53 bis 57 des genannten Buches "Charged Transfer Devices" beschrieben und können in analoger Abwandlung auch für BBD-Schaltungen aufgebaut werden, wenn zur Abtastung der Ladekondensatoren solcher BBD-Schaltungen Verstärker verwendet werden, deren Eingangswiderstand sich möglichst dem Wert Unendlich annähert. Von der im unteren Zweig liegenden Auskopplung 5 führt ein Verstärker mit dem Verstärkungsfaktor $R_A$ zur oberen Leitung und gleichzeitig ein Verstärker mit dem Verstärkungsfaktor $-(1+R_A)$ zum Vierpolresonator 6, so daß also seine Signalflußrichtung in Richtung zum Ausgang 2 zeigt.

Entsprechend ist der oberen Auskopplung 5 ein Verstärker $R_B$ nachgeschaltet, dessen Signalflußrichtung von der oberen zur unteren CTD-Leitung zeigt, und es liegt im oberen Längszweig des Schaltungsabschnittes 9 ein Verstärker mit dem Verstärkungsfaktor $-(1+R_B)$. Für die Bemessung der Schaltung gelten noch folgende Beziehungen:

$R_A, R_B$ = von der Ladung im Längszweig eines Vierpolresonators in seinen Querzweig geleiteter Anteil ($Q_{quer} = R \cdot Q_{laXngs}$;

$$R = R_A = R_B = \frac{C2}{C2+C3}$$

$(1-R) \cdot Q_{längs}$ = weitergeleitete Ladung) C1,C2,C3 = Kappazitätswerte der Umladekapazitäten an der Verweigungsstelle des linken Vierpolresonatoren

n = CTD-Ringelementeanzahl der Vierpolresonatoren

n/2 = CTD-Elementeanzahl des Koppelringes 7

$f_R$ = Resonanzfrequenz des Vierpolresonators (6,6') = $k \cdot f_T/n (k=1,2 \ldots n)$

$f_T$ = Taktfrequenz

Im vorstehenden sind also $R_A$ und $R_B$ Ladungsaufteilungen bzw. auch Ladungsverstärkungen und es ist an einzelne Teilleitungen zur besseren Übersicht unmittelbar noch der Ladungsanteil $R_A$ bzw. $R_B$ angeschrieben, so daß also in der querliegenden CTD-Leitung 10 des Vierpolresonators der Ladungsanteil $R_A$ läuft, während in der ebenfalls im Querzweig liegenden CTD-Leitung 10' des Vierpolresonators 6' der Ladungsanteil $R_B$ fließt. Zu beachten ist lediglich, daß die CTD-Leitungen 10 bzw. 10' entgegengesetztes undirektionales Übertragungsverhalten haben. Es ist bereits in den vorerwähnten deutschen Patent- bzw.

Auslegeschriften darauf hingewiesen, daß sich der Entwurf solcher Filterschaltungen auf Mikrowellenschaltungen zurückführen läßt, wie sie beispielsweise in dem Buch von Matthaei-Young Jones: Microwave Filters Impedance Matching and Coupling Structures, McGraw Hill Book Company Corp. 1964, beschrieben sind. Es hängt dies damit zusammen, daß auch CTD-Leitungen als Übertragungsleitungen aufgefaßt werden können, deren Leitungscharakter in genau der gleichen Weise berücksichtigt werden kann, wie dies bei Mikrowellenfiltern der Fall ist. Aus diesem Grund hat die in Fig. 1 dargestellte Schaltung die folgende Wirkungsweise.

Die Schaltung selbst hat den Charakter einer Weichenschaltung, und es erscheint die in den Eingang 1 eingespeiste Energie stets dann vollständig am Ausgang 2', wenn ihre Signalfrequenz $f_s$ übereinstimmt mit der im vorstehenden definierten Resonanzfrequenz $f_R$. Je weiter die Signalfrequenz $f_s$ von der Resonanzfrequenz abweicht, umso mehr Signalenergie erscheint am Ausgang 2. Benutzt man lediglich den Eingang 1 und den Ausgang 2, dann hat die Schaltung Bandpaß-Charakter.

In den Fig. 2 bis 4 sind Schaltungsstrukturen gemäß der Erfindung gezeigt, und es sind wirkungsgleiche Elemente mit gleichen Bezugshinweisen bezeichnet, so daß insoweit unmittelbar auf die Beschreibung von Fig. 1 verwiesen werden kann.

In der Schaltung von Fig. 2 wird nun die die Vierpolresonatoren 6 und 6' verbindende Koppelschaltung 4 im wesentlichen durch Verstärker V1 bis V4 realisiert. In der oberen Längsleitung, also vom Eingang 1 zum Ausgang 2' betrachtet, liegt eine erste leistungslose Signalauskopplung 5 und entsprechend ebenso in der unteren Längsleitung, also vom Eingang 1' zum Ausgang 2 betrachtet. die Signalauskopplungen 5 können dabei unmittelbnar den Vierpolresonatoren 6 bzw. 6' benachbart sein, oder es kann ihre Ankopplung über kurze CTD-Leitungsabschnitte erfolgen. Es wird nun der zum Vierpol 6 gehörenden CTD-Leitung 10 unmittelbar ein Verstärker V1 parallelgeschaltet, so daß also der Verstärker V1 am Ausgang des Vierpolresonators 6 liegt. Entsprechend wird der CTD-Leitung 10' der Verstärker V4 parallelgeschaltet. Korrespondierende Längsleitungen aufeinanderfolgender Vierpolresonatoren sind über die Leitungen 11 bzw. 11' miteinander verbunden. In diesen Längsleitungen liegen die Verstärker V2 und V3. Für den Verstärker V2 ist zu beachten, daß seine Übertragungsrichtung, d.h. also sein unidirektionales Verhalten vom Eingang 1 zum Ausgang 2' zeigt, während für den Verstärker V3 zu beachten ist, daß seine Übertragungsrichtung von Eingang 1' zum Ausgang 2 zeigt. Die Übertragungsrichtungen der Verstärker V1 bzw. V4 muß übereinstimmen mit den unidirektionalen Übertragungsrichtungen der parallelliegenden CTD-Leitungen 10 bzw. 10', so daß also der Verstärker V1 von der Signalauskopplung 5 des oberen Längszweiges zum unteren Längszweig überträgt, während der Verstärker V4 von der Signalauskopplung 5 des unteren Längszweiges in Richtung zum oberen Längszweig überträgt. Die Verstärkungsfaktoren für die Verstärker V1 bis V4 lassen sich nach folgenden Beziehungen bemessen

$$V1 = \frac{R_B(1+R_A)}{1+R_A R_B} \qquad V3 = \mp \frac{1+R_A}{1+R_A R_B}$$

$$V2 = \pm \frac{1+R_B}{1+R_A R_B} \qquad V4 = \frac{R_A(1+R_B)}{1+R_A R_B}$$

V1 bis V4 sind dabei wiederum Ladungsverstärkungen bzw. Ladungsaufteilungen, und es kann entweder V2 oder V3 mit negativem Vorzeichen als invertierender Verstärker realisiert sein, so daß also V2 und V3 entgegengesetztes Vorzeichen haben.

In der Schaltungsstruktur von Fig. 2 ist zu erkennen, daß auch die einzelnen Teilabschnitte der Koppelschaltung 4 unidirektionales Übertragungsverhalten haben, was dort durch die Signalflußrichtung der Verstärker V1 bis V4 sichergestellt wird.

In Weiterbildung dieses Gedankens sind in den Fig. 3 und 4 noch Schaltungen gezeigt, bei denen durch die geeignete Bemessung der Verstärkungsfaktoren noch zwei Verstärker eingespart werden können. Gibt man beispielsweise durch geeignete Bemessung der Umladekapazitäten C2 bzw. C3 den Verstärkern V2 bzw. V4 den Verstärkungsfaktor 1, dann können diese Verstärker entfallen. Um das unidirektionale Übertragungsverhalten in den Schaltungen nach den Fig. 3 und 4 sicherzustellen, ist die im oberen Längszweig liegende Verbindungsleitung 11 zur Verbindung der Längszweige der Vierpolresonatoren 6 und 6' ebenfalls als CTD-Leitung ausgebildet, deren Übertragungsrichtung wiederum durch den miteingezeichneten Pfeil kenntlich gemacht ist. In der Schaltung von Fig. 3 ist die Signalauskopplung 5 dabei unmittelbar an die im Längszweig liegende CTD-Leitung 11 angekoppelt, während in der Schaltung von Fig. 4 die Signalauskopplung 5 an die parallelliegende CTD-Leitung 10 des Vierpolresonators 6 angekoppelt ist. Hinsichtlich der Ankopplungen ist in jedem Fall dafür zu sorgen, daß für die Querzweige eine den eingangs angegebenen Beziehungen entsprechende Ladung ausgekoppelt wird.

Die vorstehend am Beispiel eines zweikreisigen Filters angestellten Überlegungen haben entsprechend auch dann Gültigkeit, wenn es darum geht, mehrgliedrige Filterschaltungen zu realisieren, deren einzelne Vierpolresonatoren über Koppelschaltungen untereinander verbunden sind.

## Patentansprüche

1. Elektrische Filterschaltung mit aus einzelnen CTD-Elementen bestehenden CTD-Leitungen (C1—C3) unter Verwendung von Vierpolresonatoren (6,6') die jeweils als in sich geschlossene Leitungsschleife ausgebildet sind und die das frequenzabhängige Übertragungsverhalten der Filterschaltung bestimmen und bei der weiterhin aufeinanderfolgende Vierpolresonatoren über eine Koppelschaltung (4) miteinander verbunden sind, dadurch gekennzeichnet, daß parallel zum Ein- und/oder Ausgang des einzelnen Vierpolresonators (6,6') Verstärker (V1,V4) geschaltet sind, deren Signalflußrichtung übereinstimmt mit der der parallel liegenden CTD-Leitungen (10,10'), und daß aufeinanderfolgende Vierpolresonatoren (6,6') verbindende Längsleitungen (11,11') der Koppelschaltung (4) unidirektionales Übertragungsverhalten haben und in wenigstens einer dieser Längsleitungen (z.B. 11') ein invertierender Verstärker (V3) enthalten ist. (Fig. 2)

2. Filterschaltung nach Anspruch 1, dadurch gekennzeichnet, daß nur dem Ausgang des vorgeschalteten CTD-Vierpolresonators (6) ein Verstärker (V1) parallel geschaltet ist und eine der Längsleitungen (z.B. 11) der Koppelschaltung (4) vollständig als CTD-Leitung ausgebildet ist.

3. Filterschaltung nach Anspruch 1 oder 2, dadurch gekennzeichnet, daß die Auskopplung (5) für den parallel liegenden Verstärker (V1) unmittelbar aus der benachbarten CTD-Leitung (10) des Vierpolresonators (6) erfolgt.

## Claims

1. An electric filter circuit which comprises individual CTD-elements forming CTD-lines (C1—C3) connected as four-pole resonators (6,6') each designed as a closed loop and determining the frequency-dependent transmission behaviour of the filter circuit, and wherein successive four-pole resonators are connected in succession via a coupling circuit (4), characterised in that a respective amplifier (V1, V4) is connected in parallel to the input and/or output of the individual four-pole resonator (6, 6'), in such manner that the signal flow direction of the amplifier is the same as that of the associated parallel CTD-line (10, 10'), and that the coupling circuit (4) which connects successive four-pole resonators (6, 6') contains series lines (11, 11') that have a unidirectional transmission behaviour, with an inverting amplifier (V3) contained in at least one of these series lines (e.g. 11').

2. A filter circuit as claimed in Claim 1, characterised in that only the output of a preceding CTD-four-pole resonator (6) has a parallel-connected amplifier (V1), and one of the series lines (e.g. 11) of the coupling circuit (4) is completely formed by a CTD-line.

3. A filter circuit as claimed in Claim 1 or Claim 2, characterised in that the output coupling (5) for the parallel amplifier (V1) is obtained directly from the neighbouring CTD-line (10) of the four-pole resonator (6).

## Revendications

1. Montage de filtre électrique à conducteurs CTD (C1—C3) constitués par des éléments CDT individuels, avec mise en oeuvre de résonateurs quadripoles (6, 6') dont chacun constitue une boucle de ligne fermée sur elle-même et qui déterminent le comportement de transfert ou de transmission, en fonction de la fréquence, du montage de filtre, du type dans lequel les résonateurs quadripoles successifs sont reliés entre eux par des circuits de couplage (4), caractérisé par le fait qu'en parallèle sur l'entrée et/ou sur la sortie de résonateurs quadripoles individuels · (6, 6') sont montés des amplificateurs (V1, V4) dont la direction de passage des signaux correspond à celle des conducteurs CTD (10, 10') situés en parallèle et que les conducteurs longitudinaux (11, 11') du circuit de couplage (4) qui relient des résonateurs successifs (6, 6') possèdent un comportement de transmission unidirectionnel, alors que dans au moins l'un (par exemple 11') de ces conducteurs longitudinaux est disposé un amplificateur inverseur (V3).

2. Montage de filtre électrique selon la revendication 1, caractérisé par le fait que l'amplificateur (V1) est monté en parallèle seulement sur la sortie du résonateur quadripole CTD amont (6) et, un des conducteurs longitudinaux (par exemple 11) du circuit de couplage (4) est entièrement réalisé sous la forme d'un conducteur CTD.

3. Montage de filtre électrique selon la revendication 1 ou 2, caractérisé par le fait que le découplage (5) pour l'amplificateur (V1) monté en parallèle s'opère directement au niveau du conducteur CTD voisin (10) du résonateur quadripole (6).

0 007 629

FIG1

FIG2

FIG3

FIG4